# EUROPEAN PATENT APPLICATION

(11) **EP 2 261 293 A1**
(43) Date of publication of application: **15.12.2010**
(21) Application number: 09728341.0
(22) Date of filing: 24.03.2009
(51) Int. Cl.: C09J 163/00, C09J 7/02, C09J 11/06, C09J 119/00, H01L 23/12, H05K 3/46

(54) **RESIN COMPOSITION, RESIN-CONTAINING CARRIER MATERIAL, MULTI-LAYERED PRINTED CIRCUIT BOARD, AND SEMICONDUCTOR DEVICE**

(30) Priority: 31.03.2008 JP 2008089269; 03.07.2008 JP 2008174306
(71) Applicant: Sumitomo Bakelite Co., Ltd., Shinagawa-ku Tokyo 140-0002 (JP)
(72) Inventor: KOMIYATANI, Toshio, Akita-shi Akita 011-8510 (JP); KONDO, Masayoshi, Akita-shi Akita 011-8510 (JP)
(74) Representative: Müller, Christian Stefan Gerd
(86) International application number: PCT/JP2009/001286
(87) International publication number: WO 2009/122671

(57) **Abstract**

There is disclosed a resin composition used for forming a resin layer in a sheet-formed carrier material with a resin, comprising a poly-functional epoxy resin (a) having three or more glycidyl ether groups with an epoxy equivalent of 100 to 300, a compound (b) having one or more carboxyl groups with a melting point of equal to or more than 50 degrees C and equal to or less than 230 degrees C, and a curing agent (c).

## Description

### TECHNICAL FIELD

The present invention relates to a resin composition, a carrier material with a resin, a multi-layered printed circuit board and a semiconductor device.

### BACKGROUND ART

Recently, electronic devices assembled with a higher density have accelerated multilayering of a circuit board such as a flexible printed circuit board used in such a device. A build-up method is technique employed for forming such a multilayer circuit board by lamination. A build-up method refers to a method in which interlayer connection is formed between monolayers while a resin layer made of a resin alone and a conductor layer are piled.

Such build-up methods are generally classified into those where a via hole is formed in a resin layer before forming interlayer connection and those where an interlayer connecting part is formed before laminating resin layers. Furthermore, different types of interlayer connecting parts are used, depending on, for example, whether a via hole is formed by a plating or conductive paste.

There has been disclosed technique allowing for stacked via, densification and more compact interconnection designing, wherein a fine via hole for interlayer connection is formed in a resin layer by laser and the via hole is filled with a conductive adhesive such as a copper paste for electric connection (see, for example, Patent document 1).
However, this method may be inadequately reliable because interlayer electric connection is achieved via a conductive adhesive. Furthermore, the method requires advanced techniques for filling a fine via hole with a conductive adhesive. Therefore, it is difficult to deal with further requirement for a finer interconnection pattern.

Thus, in place of the approach that a via hole is filled with a conductive adhesive, a metal protrusion (conductor post) is employed. However, even in the case where a conductor post is used, there has been disclosed a procedure where the conductor post physically removes an interlayer adhesive during interlayer connection to connect to a conductor pad (see, for example, Patent document 2).
Patent document 1: Japanese published unexamined application No. H08 (1996)-316598.
Patent document 2: Japanese published unexamined application No. 2000-183528.

### DISCLOSURE OF THE INVENTION

However, in the method of the related art, an adhesive layer between a conductor post and a conductor pad is removed at a high temperature during, for example, pressing while the conductor post is molten to achieve electric connection. Therefore, variation in an internal temperature of the press may cause the adhesive layer to first cure, leading to inadequate connection reliability. Furthermore, because the system becomes hot, a resin component in the adhesive layer may flow out to the outside of the substrate, leading to reduced precision in a plate thickness or contamination of neighboring substrates by the outflowing resin component.

In view of the aforementioned circumstances, an objective of the present invention is to provide a resin composition, a carrier material with a resin, a multi-layered printed circuit board and a semiconductor device, allowing for easy and excellent inter-substrate electric bonding and prevention of outflowing of a resin during adhesion.

According to the present invention, there is provided a resin composition used for a resin layer in a sheet-formed carrier material with a resin for bonding between substrates in which a metal conductive material is formed, comprising: a polyfunctional epoxy resin (a) having three or more glycidyl ether groups with an epoxy equivalent of 100 to 300, a compound (b) having one or more carboxyl groups with a melting point of equal to or more than 50 degrees C and equal to or less than 230 degrees C or less, and a curing agent (c).

According to the present invention, there is also provided a carrier material with a resin, wherein the resin composition is laminated on a carrier material.

According to the present invention, there is also provided a multi-layered printed circuit board, wherein the carrier material with a resin is laminated on one side or both sides of an inner circuit board and they are pressed with heating.

According to the present invention, there is also provided a semiconductor device comprising the multi-layered printed circuit board.

According to this invention, a resin composition containing a polyfunctional epoxy resin having three or more glycidyl ether groups and a compound having one or more carboxyl groups with a melting point of 50 degrees C to 230 degrees C intervenes between substrates, and the resin composition allows an oxide film in a metal conductive material to be reduced and a three-dimensionally cross-linked adhesive layer to be formed between the substrates without outflowing. Thus, by a convenient method, electric connection between substrates can be successfully achieved and the substrates can be firmly bonded to each other.

The present invention can provide a resin composition, a carrier material with a resin, a multi-layered printed circuit board and a semiconductor device, which allows for convenient and satisfactory electric bonding between substrates while outflowing of a resin during adhesion is prevented.

### BRIEF DESCRIPTION OF THE DRAWINGS

The above objectives and other objectives, features and advantages of the present invention will be further understood with reference to preferred embodiments described below and the accompanying drawings below.

FIG. 1 is cross-sectional views illustrating a process for manufacturing a multi-layered printed circuit board using a resin composition of the present invention.
FIG. 2 is cross-sectional views illustrating a process for manufacturing a multi-layered printed circuit board using a resin composition of the present invention.
FIG. 3 is cross-sectional views illustrating a process for manufacturing a multi-layered printed circuit board using a resin composition of the present invention.

### BEST MODE FOR CARRYING OUT THE INVENTION

There will be detailed a resin composition, a carrier material with a resin, a multi-layered printed circuit board and a semiconductor device according to the present invention.

A resin composition of the present invention is a resin composition used for a resin layer in a sheet-formed carrier material with a resin which bonds circuit boards (substrates) in which a conductor post or conductor pad (metal conductive material) is formed. This resin composition includes a polyfunctional epoxy resin (a) having three or more glycidyl ether groups with an epoxy equivalent of 100 to 300, a compound (b) having one or more carboxyl groups with a melting point of equal to or more than 50 degrees C and equal to or less than 230 degrees C or less, and a curing agent (c).

A resin composition of the present invention contains a polyfunctional epoxy resin (a) having three or more glycidyl ether groups with an epoxy equivalent of 100 to 300. Thus, the resin composition can be reliably heat resistant. Examples of the polyfunctional epoxy resin (a) include, but not limited to, phenol novolac epoxy resins, cresol novolac epoxy resins, glycidyl amine type epoxy resins, aminotriazine phenol novolac epoxy resins, aminotriazine cresol novolac epoxy resins, naphthalene framework type epoxy resins, solid epoxy resins and cyclopentadiene type epoxy resins, which can be used alone or in combination. Among these, a solid epoxy resin represented by general formula (1) can be more preferably used.

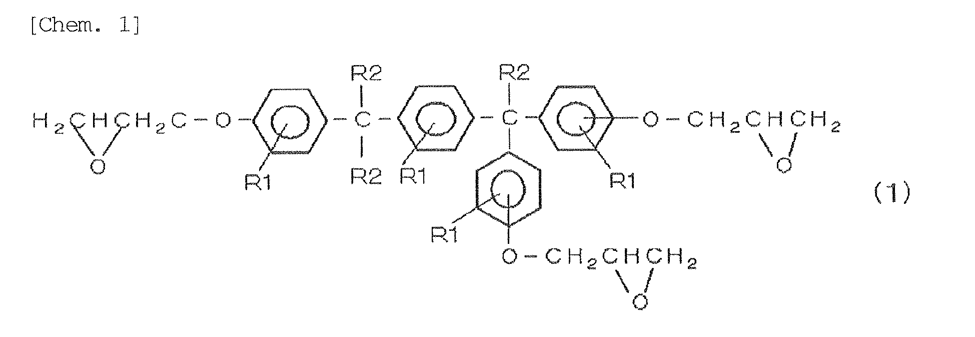

[In formula (1), R1 represents halogen or alkyl group having 1 to 3 carbon atoms, and can be identical or different between each other. R2 represents hydrogen or methyl group, and can be identical or different between each other.]

In general formula (1), each of R2 is more preferably methyl. More specifically, there can be used, but not limited to, those represented by formula (2) or (3).

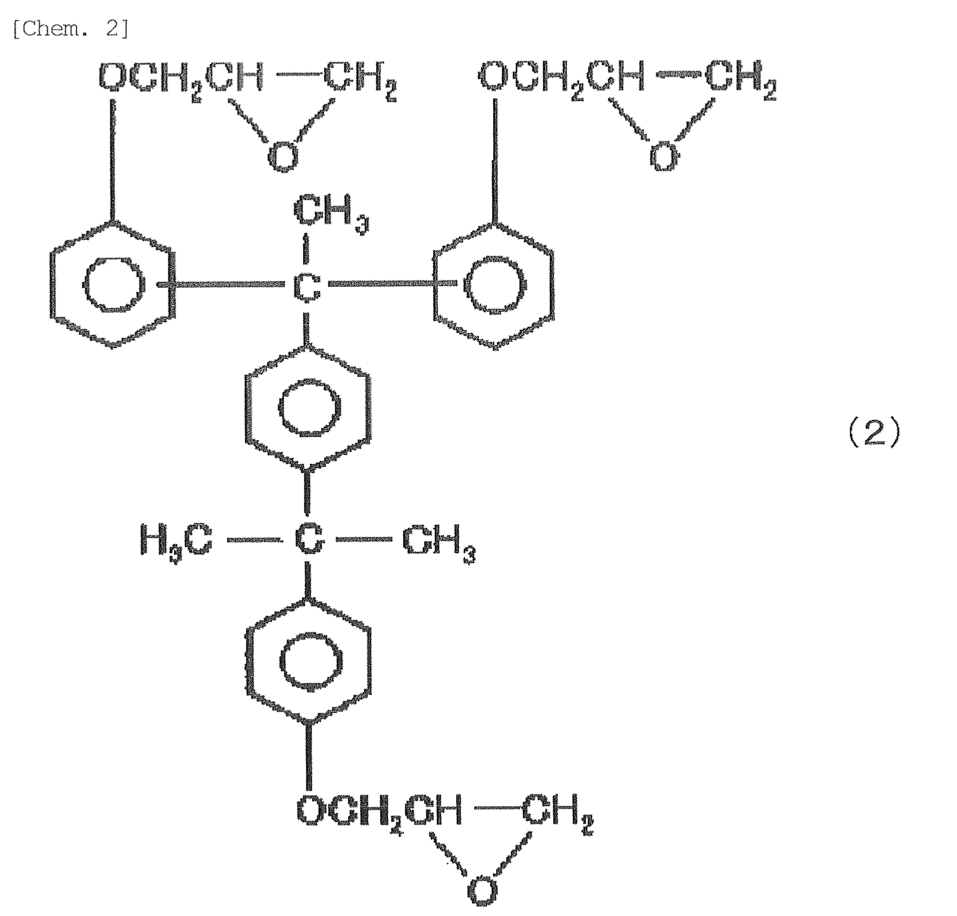

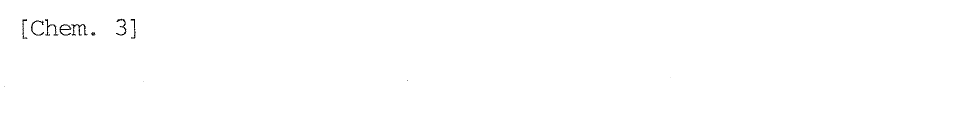

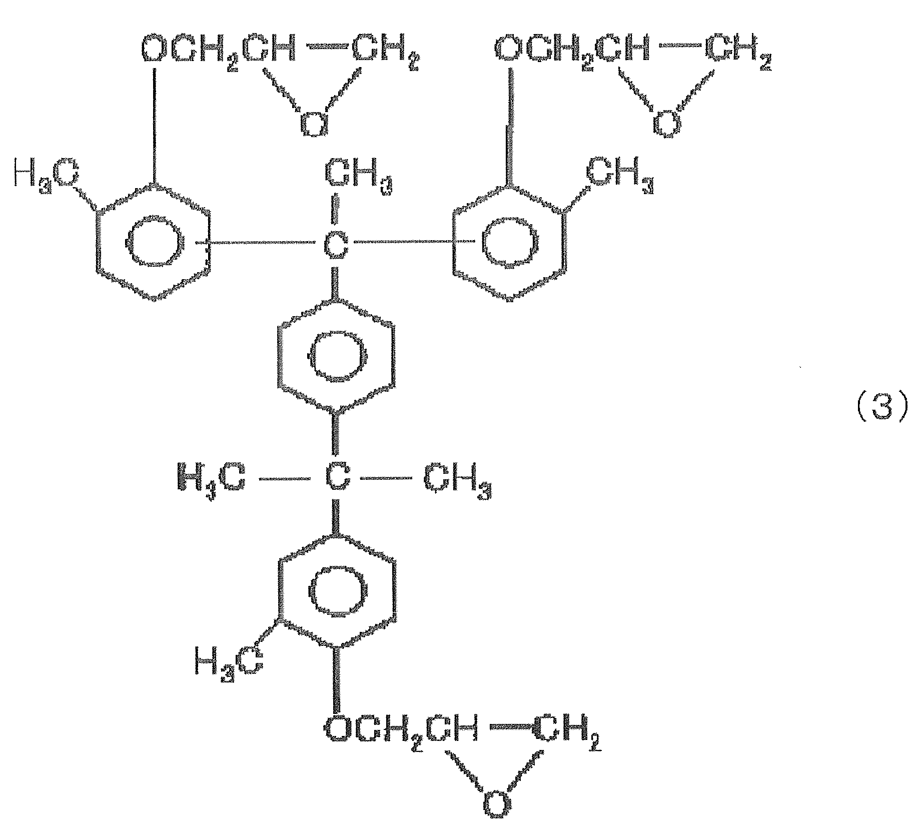

A content of the polyfunctional epoxy resin (a) is, but not limited to, preferably equal to or more than 60 parts by weight and equal to or less than 80 parts by weight to 100 parts by weight as the total of the polyfunctional epoxy resin (a) and the curing agent (c). With the content being within the above range, adhesiveness can be improved.

The resin composition of the present invention contains a compound (b) having one or more carboxyl groups with a melting point of equal to or more than 50 degrees C and equal to or less than 230 degrees C. A boiling point or decomposition point of the compound (b) having one or more carboxyl groups can be equal to or more than 240 degrees C. When a conductor post having a metallic cover layer and a conductor pad (conductor circuit) are bonded via a metal by melting a metallic cover layer as described later, the compound having one or more carboxyl groups removes an oxide film of the conductor pad in the receiving side and an oxide in the metallic cover layer surface to improve wettability. Generally, since a temperature in the metal bonding is often equal to or more than 240 degrees C, a boiling point or decomposition point of the compound (b) having one or more carboxyl groups is preferably equal to more than 240 degrees C. If the boiling point or the decomposition point is less than 240 degrees C, a void (cavity) may be formed between layers or delamination may occur, leading to decreased reliability. Furthermore, since the carboxyl-containing compound (b) is most activated when a temperature exceeds its melting point, the melting point is preferably equal to or less than 230 degrees C. If the melting point is equal to or less than 50 degrees C, the compound (b) having one or more carboxyl groups may outflow from the interlayer adhesive layer. Therefore, the melting point is preferably equal to or more than 50 degrees C.

A content of the compound (b) having one or more carboxyl groups is preferably equal to or more than 3 parts by weight and equal to or less than 15 parts by weight to 100 parts by weight as the total of the polyfunctional epoxy resin (a) and the curing agent (c). With the content being within this range, the metal surface can be adequately reduced by the compound, resulting in satisfactory metal bonding. Furthermore, when it is used as a sheet carrier material, it can be favorably handled as a film.

The carboxyl-containing compound (b) is preferably, but not limited to, an aromatic carboxylic acid or a linear saturated dicarboxylic acid. Examples of the aromatic carboxylic acid can include those represented by formulas (4) to (6). Examples of the linear saturated dicarboxylic acid can include those represented by formula (7) as below.

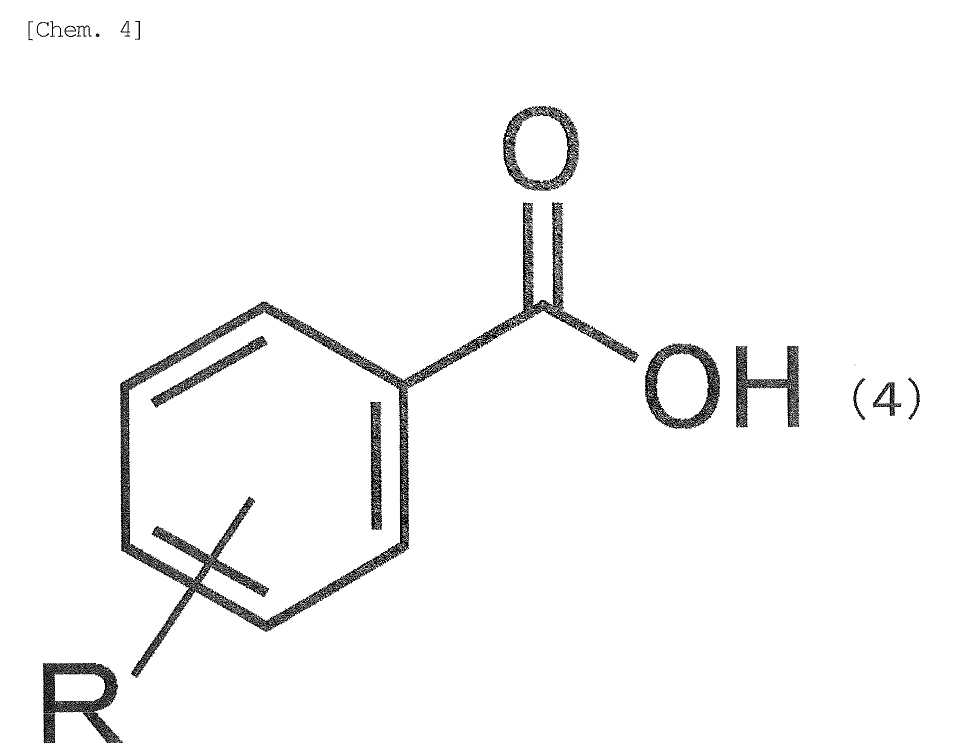

[In formula 4, R represents halogen or alkyl having 1 to 12 carbon atoms.]

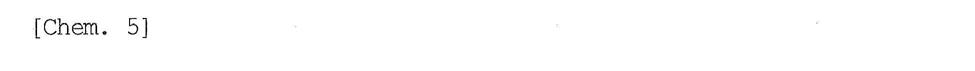

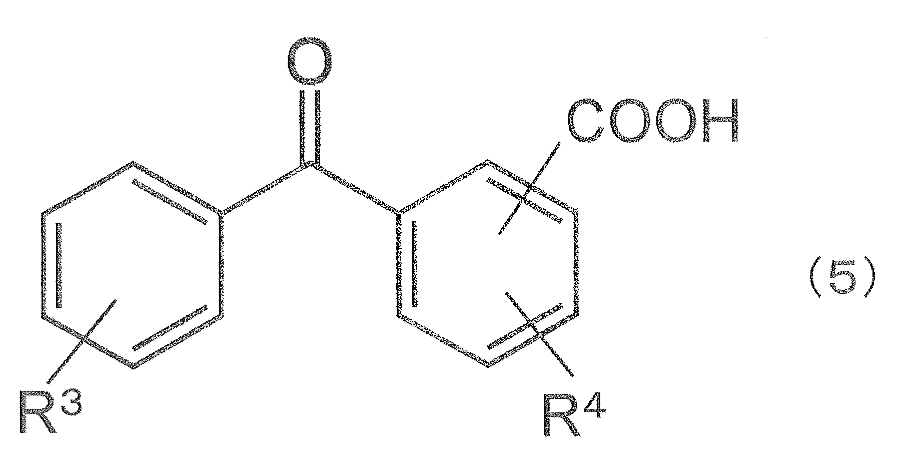

[In formula (5), R³ and R⁴ represent halogen or alkyl having 1 to 12 carbon atoms, and can be identical or different between each other.]

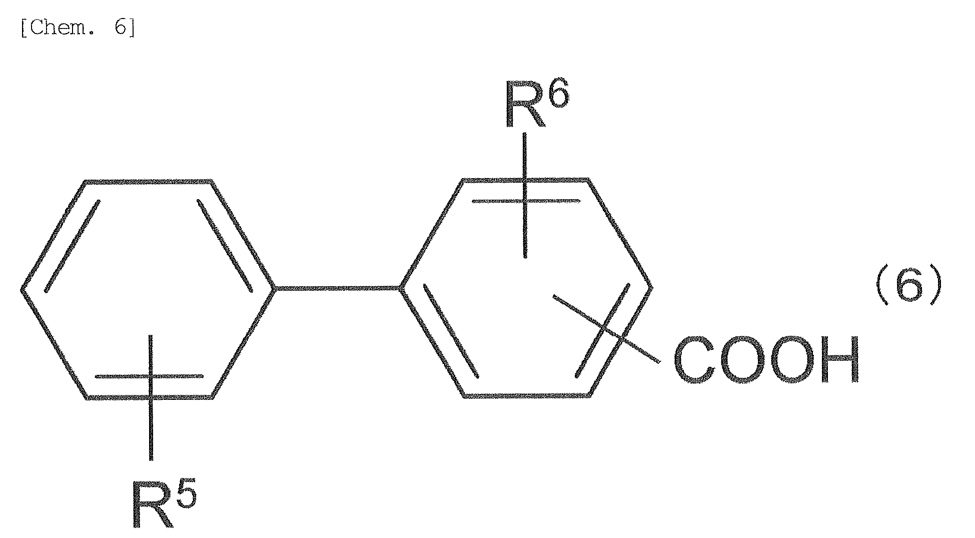

[In formula (6), R⁵ and R⁶ represent halogen or alkyl having 1 to 12 carbon atoms, and can be identical or different between each other.]

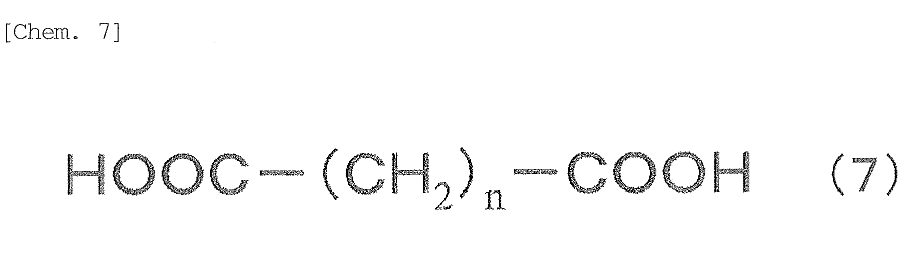

[In formula (7), n is a positive number of 1 to 12.]

More specific examples of the compound (b) having one or more carboxyl groups include 2,3-pyrazinedicarboxylic acid, cyclohexanedicarboxylic acid, cyclobutanedicarboxylic acid, benzoic acid, o-methylbenzoic acid (o-toluic acid), m-methylbenzoic acid (m-toluic acid), p-methylbenzoic acid (p-toluic acid), coumarin-3-carboxylic acid, benzophenone-2-carboxylic acid, sebacic acid, 1,2,3,4-cyclopentanetetracarboxylic acid, 2-biphenylcarboxylic acid and 4-biphenylcarboxylic acid, which can be used alone or in combination of two or more.

The resin composition of the present invention can further contain a synthetic rubber elastomer. Thus, when it is used as a sheet-formed carrier material, the resin composition exhibiting excellent film processability can be obtained. The synthetic rubber elastomer is preferably carboxylic acid-modified because its adhesiveness to a polyimide film is improved. For example, it can be a common rubber such as a carboxylic acid-modified NBR, a carboxylic acid-modified acrylic rubber and a carboxylic acid-modified butadiene rubber which are commercially available.
A content of the synthetic rubber elastomer is, but not limited to, preferably equal to or more than 5 parts by weight and equal to or less than 30 parts by weight to 100 parts by weight as the total of the polyfunctional epoxy resin (a) and the curing agent (c). With the content being within this range, the resin composition in which adhesiveness and heat resistance are well-balanced can be provided. Furthermore, a weight average molecular weight of the synthetic rubber elastomer is preferably equal to or more than 500,000. Thus, a resin composition exhibiting excellent moldability in pressing with heating can be provided.

The resin composition of the present invention contains a curing agent (c). The curing agent (c) can contain a novolac phenol resin. Preferable examples of novolac phenol resin include, but not limited to, aminotriazine novolac type phenol resins and aminotriazine cresol novolac type phenol resins. The presence of an amino group causes a reaction of some epoxy groups due to heat during application, leading to B stage. Thus, outflow during laminating press can be prevented. Furthermore, nitrogen in the triazine moiety contributes to flame retardancy. A content of the novolac phenol resin is, but not limited to, preferably 0.8 to 1.2 equivalent to the polyfunctional epoxy resin (a) in the present invention. With the content being within this range, a resin composition which is excellent in curability and warpage can be provided.

The resin composition of the present invention can further contain a coupling agent for improving adhesiveness, a defoamer or leveling agent for minimizing foaming or repelling during application, a small amount of a curing accelerator for adjusting a gelling time and/or an inorganic filler.

There will be described a carrier material with a resin.

The carrier material with a resin of the present invention is a carrier material with a resin in which the above resin composition is laminated on the carrier material.

Examples of the carrier material include, but not limited to, metal foils such as copper and copper alloys and aluminum and aluminum alloys; and resin films such as fluororesins, polyimide resins and polyester resins including polybutyrene terephthalate and polyethylene terephthalate.

The carrier material with a resin is generally prepared by, but not limited to, coating a varnish to a carrier material. Desirably, a solvent used for preparing a varnish can highly dissolve a resin composition, but a poor solvent can be used as long as it does not adversely affect the system. Examples of a good solvent include DMF, MEK and cyclohexanone.
For preparing a varnish, a solid content in the resin composition is, but not limited to, preferably 20 to 80 parts by weight, particularly preferably 30 to 60 parts by weight.

The above varnish can be coated to the carrier material and dried at 80 to 200 degrees C, to obtain a carrier material with a resin. A resin thickness after the application and the drying is, but not limited to, preferably within ± 20 % of a conductor post height. With the resin thickness being within the range, a carrier material exhibiting good moldability which can eliminate void generation around a conductor post can be obtained.

There will be described a multi-layered printed circuit board.

A multi-layered printed circuit board of the present invention can be produced by laminating the carrier material with a resin on one side or both sides of an inner circuit board and they are pressed with heating.

The multi-layered printed circuit board is prepared by laminating a resin layer of the above carrier material with a resin on one or both sides of an inner-layer circuit board with a solder bump and then melting the solder bump for interlayer electric bonding while an oxide film in the solder surface and an oxide film in the copper foil surface as a face to be bonded are reduced, to achieve satisfactorily strong bonding. Furthermore, the resin composition of the present invention does not have to be removed by washing after the solder bonding and can be heated as it is, to give a three-dimensionally cross-linked resin, which can give a multi-layered printed circuit board with higher adhesive strength.

A process for manufacturing this multi-layered printed circuit board will be described with reference to FTGs . 1 to 3. Here, the process will be described, as an example, a multi-layered printed circuit board 310 having three substrates prepared by bonding a single-sided circuit board 120 having an interconnection layer in one side with a double-sidled circuit board 220 having interconnection layers in both sides via a sheet formed carrier material with a resin.

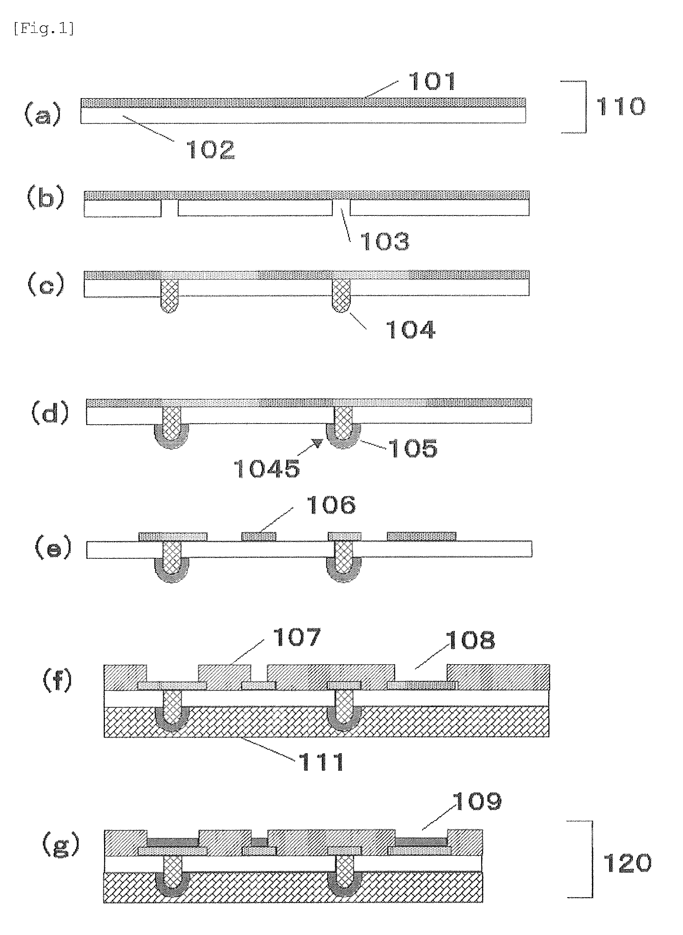

First, there will be described a process for manufacturing a single-sided circuit board 120 with reference to FIG. 1. A laminated plate 110 where a copper foil 101 is laminated on a supporting base 102 is prepared (FIG. 1(a)) Then, from the side of the supporting base 102, a supporting-base opening 103 is formed by UV laser (FIG. 1(b)). Next, the inside of the supporting-base opening 103 is electrolytically plated with copper to form a copper post 104 protruding from the surface of the supporting base 102 in the side opposite to the copper foil 101 (FIG. 1 (c)). Subsequently, the copper post 104 is solder-plated to form a metallic cover layer 105, giving a conductor post 1045 (FIG. 1(d)). Then, the copper foil 101 in the laminated plate 110 is etched to form an interconnection pattern 106 (FIG. 1(e)). Next, a liquid resist is applied by printing to form a surface coating 107 and then a surface-coating opening 108 is formed (FIG. 1(f)). Then, a conductor pad 109 is formed in the surface-coating opening 108. Then, a sheet carrier material with a resin of the present invention is laminated by a vacuum laminator to form an adhesive layer 111. Then, after outline machining, a single-sided circuit board 120 is provided (FIG. 1(f)).

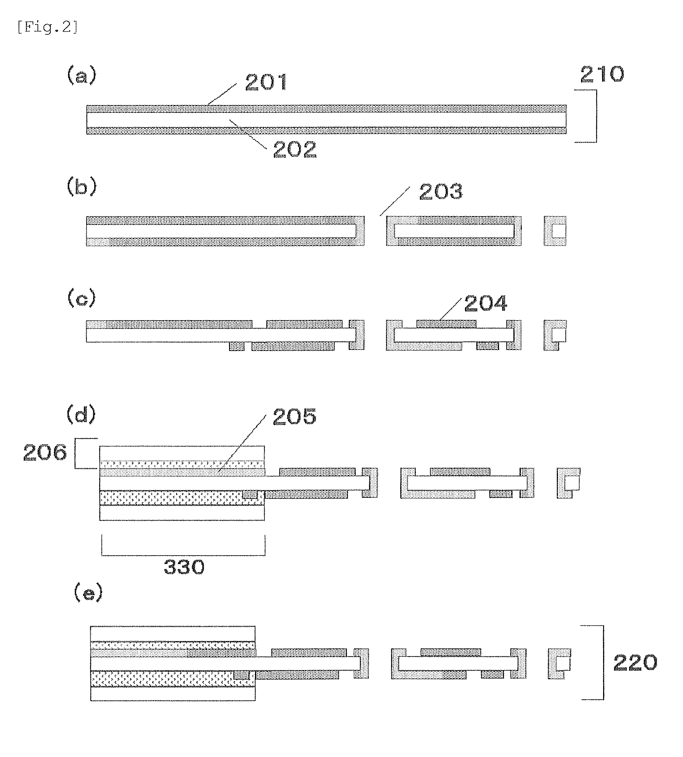

Next, there will be described a process for manufacturing a double-sided circuit board 220 with reference to FIG. 2. A laminated plate 210 in which copper foils 201 are formed in both sides of a supporting base 202 is prepared (FIG. 2 (a)). Then, a hole is formed by drilling the laminated plate 210, directly plated, and then electrolytically plated with copper to form a through-hole 203 (FIG. 2 (b)). A copper pad 204 which can receive an interconnection pattern 205 and a conductor post 1045 is formed by etching (FIG. 2(c)). Then, in an interconnection pattern 205 in a region corresponding to a flexible region 330, a surface coating 206 is formed by a polyimide layer and a thermosetting adhesive layer (FIG. 2 (d)) . Finally, the product is cut into a shape with a predetermined size to give a double-sided circuit board 220 (FIG. 2(e)).

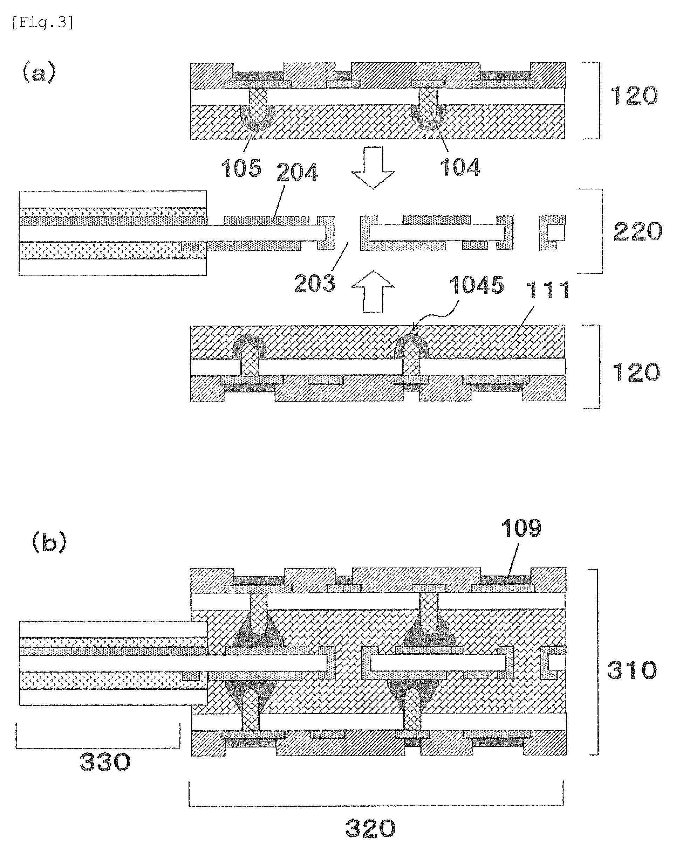

Next, there will be described a method for attaching a single-sided circuit boards 120 on both sides of the double-sided board 220 with reference to FIG. 3. First, the adhesive layer 111 formed in the single-sided circuit board 120 is softened by heating and pressing under the first conditions. As the first conditions, a heating temperature is preferably 100 to 200 degrees C, and a pressure is preferably 0.01 to 1 MPa, more preferably 0.1 to 0.5 MPa. Then, using a jig with a pin guide for alignment, the single-sided circuit boards 120 are laid up on the double-sided circuit board 220 (FIG. 3(a)). Then, they are partly temporary-bonded by a spot heater. Then, the conductor post 1045 is made in contact with the conductor pad 204 by a vacuum press, and then pressed until the conductor post is deformed, to fill the through-hole 203 in the double-sided circuit board 220 with the adhesive layer 111. Then, by pressing by a hydraulic press, the metallic cover layer 105 in the conductor post 1045 and the copper pad 204 in the double-sided circuit board 220 is heated and pressed via the adhesive layer 111 under the second conditions for solder melting, permitting electric connection between the circuit boards 120 and 220. Then, as necessary, the adhesive layer 111 is heated (after-baking), to bond the double-sided circuit board 220 to the single-sided circuit boards 120. Thus, there is provided a multi-layered printed circuit board 310 having a multilayer region 320 and a flexible region 320 (FIG. 3(b)). As the second conditions, a heating temperature is preferably 220 to 260 degrees C and a pressure is preferably 0.001 to 0.01 MPa. By the after-baking, the adhesive layer 111 can be completely cured, to further improve adhesive strength. The step is conducted preferably at a temperature of, but not limited to, 160 to 200 degrees C. In terms of the after-baking, the adhesive layer 111. can be three-dimensionally cross-linked simultaneously with solder melting, or alternatively, the pad 109 in the single-sided circuit board 120 and the conductor post 1045 in the single-sided circuit board 102 can be solder-bonded to form a further multi-layered printed circuit board.

A semiconductor element can be mounted on this multi-layered printed circuit board to give a semiconductor device.

The effects of this embodiment will be described with reference to FIG. 3. When the metallic cover layer 105 covering the surface of the copper post 104 is molten for electrically bonding the circuit boards, a resin composition of the present invention can reduce an oxide film in the surface of the conductor post 1045 and an oxide film in the surface of the copper pad 204 to be bonded, permitting excellent bonding with higher adhesive strength. Furthermore, the resin composition of the present invention does not have to be removed by washing after the bonding of the conductor post 1045 and the copper pad 204 and can be heated as it is, to give a three-dimensionally cross-linked resin. It can, therefore, be a highly adhesive material for interlayer connection in a multi-layered printed circuit board.

Although there have been described embodiments of the present invention, these are merely for illustrative purposes only and various configurations other than those described above can be employed.

### EXAMPLES

The present invention will be further specifically described by, but not limited to, Examples.

### (Example 1)

In a vessel were weighed 40 parts by weight of a naphthalene framework type tetrafunctional epoxy resin (Dainippon Ink And Chemicals, Incorporated., Development No. EXA-4700), 30 parts by weight of a dicyclopentadiene type epoxy resin (Dainippon Ink And Chemicals, Incorporated, HP-7200), 30 parts by weight of a novolac type phenol resin (Sumitomo Bakelite Co., Ltd. PR-53647) and 100 parts by weight of acetone, and the mixture was stirred for dissolution, and to 100 parts by weight of the resin composition was added 3 parts by weight of p-toluic acid having a melting point of 180 degrees C (Kanto Chemical Co., Inc., Reagent grade) and the mixture was stirred for dissolution to give a varnish. To an antistatic-treated PET film with a thickness of 25 µm was coated the varnish to a thickness of 15 µm after drying by a comma knife type coater to prepare, after drying, a sheet carrier material with a resin.

### (Example 2)

In a vessel were weighed 20 parts by weight of a glycidyl amine type trifunctional epoxy resin (JER Company, Epicoat 630), 40 parts by weight of a dicyclopentadiene type epoxy resin (Dainippon Ink And Chemicals, Incorporated, HP-7200), 40 parts by weight of a novolac type phenol resin (Sumitomo Bakelite Co., Ltd., PR-53647) and 100 parts by weight of acetone, and the mixture was stirred for dissolution, and to 100 parts by weight of the resin composition was added 15 parts by weight of 4-biphenylcarboxylic acid having a melting point of 225 degrees C (Kanto Chemical Co., Inc., Reagent grade) and the mixture was stirred for dissolution to give a varnish. This was coated by a comma coater to such a thickness that an adhesive thickness was to be 15 µm and dried as described in Example 1, to provide a sheet-formed carrier material with a resin.

### (Example 3)

In a vessel were weighed 65 parts by weight of a trifunctional solid epoxy resin (Nippon Kayaku Co., Ltd., NC-6000), 35 parts by weight of a novolac type phenol resin (Sumitomo Bakelite Co., Ltd., PR-53647) and 100 parts by weight of acetone, and the mixture was stirred for dissolution, and to 100 parts by weight of the resin composition was added 10 parts by weight of p-toluic acid having a melting point of 180 degrees C, and the mixture was stirred for dissolution to give a varnish. This was coated by a comma coater to such a thickness that an adhesive thickness was to be 15 µm and dried as described in Example 1, to provide a sheet-formed carrier material with a resin.

### (Example 4)

To a varnish prepared as described in Example 3 was added 15 parts by weight of a carboxyl group-modified acrylic rubber (Nagase ChemteX Corporation, SG-708-6) and the mixture was stirred, and the mixture was coated by a comma coater such a thickness that an adhesive thickness was to be 15 µm as described in Example 1 and then dried to prepare a sheet carrier material with a resin.

### (Example 5)

A sheet-formed carrier material with a resin was prepared as described in Example 4, substituting sebacic acid having a melting point of 134 degrees C for p-toluic acid.

### (Example 6)

A sheet carrier material with a resin was prepared as described in Example 4, substituting benzophenone-2-carboxylic acid having a melting point of 128 degrees C for p-toluic acid.

### (Comparative Example 1)

A sheet carrier material with a resin was prepared as described in Example 1, except that p-toluic acid as a compound having one or more carboxyl groups was absent.

### (Comparative Example 2)

A sheet-formed carrier material with a resin was prepared as described in Example 1, substituting 40 parts by weight of a polycyclic aromatic type bifunctional epoxy resin (JER Company, YX-8800) and 25 parts by weight of a bisphenol-A type epoxy resin (Dainippon Ink And Chemicals, Incorporated, 840S) for a naphthalene-framework type tetrafunctional epoxy resin and a dicyclopentadiene type epoxy resin, respectively, and using 35 parts by weight of a novolac type phenol resin (Sumitomo Bakelite Co., Ltd., PR-53647).

### (Comparative Example 3)

A sheet-formed carrier material with a resin was prepared as described in Example 3, substituting 2,3-naphtalene dicarboxylic acid having a melting point of 240 degrees C for p-toluic acid. Then, the material was evaluated as described above.

Table 1 shows a component rate of a resin composition except a solvent (acetone) for a varnishes prepared in Examples 1 to 6 and Comparative Examples 1 to 3.

[Table 1]

**(Table 1)**

| | Ex.1 | Ex.2 | Ex.3 | Ex.4 | Ex.5 | Ex.6 | Comp. Ex.1 | Comp. Ex.2 | Comp. Ex3 |
|---|---|---|---|---|---|---|---|---|---|
| Naphtalene framework type tetrafunctional epoxy resin (equivalent: 160) | 40 | | | | | | 40 | | |
| Glycidyl amine type trifunctional epoxy resin (equivalent: 100) | | 20 | | | | | | | |
| Trifunctional solid epoxy resin (equivalent: 170) | | | 65 | 65 | 65 | 65 | | | 65 |
| Dicyclopentadiene type epoxy resin (equivalent: 280) | 30 | 40 | | | | | 30 | | |
| Polycyclic aromatic type bifunctional epoxy resin (equivalent: 197) | | | | | | | | 40 | |
| Bisphenol-A type epoxy resin (equivalent: 185) | | | | | | | | 25 | |
| Novolac type phenol resin | 30 | 40 | 35 | 35 | 35 | 35 | 30 | 35 | 35 |
| Benzophernne-2-carboxylic acid (melting point: 128 °C) | | | | | | 10 | | | |
| Sebacic acid (melting point: 134 °C, boiling point: 294 °C) | | | | | 10 | | | | |
| p-Toluic acid (meeting point: 180 °C, boiling point: 275 °C) | 3 | | 10 | 10 | | | | 3 | |
| 4-Biphenylcarboxylic acid (melting point: 225 °C, decomposition point: 300 °C or more) | | 15 | | | | | | | |
| 2,3-Naphthalene dicarboxylic acid (melting point: 240 °C, decomposition point: 300 °C or more) | | | | | | | | | 10 |
| Carboxyl-modified acrylic rubber (weight average molecular weight: 700,000) | | | | 15 | 15 | 15 | | | |

### (Preparation of a multilayer flexible circuit board)

Multilayer flexible circuit boards were prepared using sheet carrier materials with a resin having a thickness of 25 µm prepared in Examples 1 to 6 or Comparative Examples 1 to 3. A manufacturing process therefor will be described.

### 1. Preparation of an outer single-sided circuit board

An outer single-sided circuit board 120 was prepared as shown in FIG. 1. In a single-sided laminated plate 110 (Ube Industries, Ltd., Upisel N) where a copper foil 101 with a thickness of 12 µm was laminated on a supporting base 102 as a polyimide film with a thickness of 25 µm, a supporting-base opening 103 with a diameter of 100 µm was formed by UV laser from the side of the supporting base 102, and was desmeared by an aqueous solution of potassium permanganate. The inner surface of the supporting-base opening 103 was electrolytically plated with copper, to form a copper post 104 which protruded from the surface of the supporting base 102 in the side opposite to the copper foil 101 by a height of 15 µm, and then solder-plated to form a metallic cover layer 105 with a thickness of 15 µm, giving a conductor post 1.045. Then, the copper foil 101 in the single-sided laminated plate 110 was etched to form an interconnection pattern 106, and then a liquid resist (Hitachi Chemical Co., Ltd., SR9000W) was applied by printing to form a surface coating 107. Subsequently, a sheet carrier material with a resin with a thickness of 25 µm prepared in each of Examples 1 to 6 and Comparative Examples 1 to 3 was laminated by a vacuum laminator to form an adhesive layer 111. Finally, the product was shaped into the laminated part to give an outer single-sided circuit board 120.

### 2. Preparation of an inner flexible circuit board

An inner flexible circuit board 220 was prepared as shown in FIG. 2. In a two-layer double-sided plate 210 (Mitsui Chemicals Inc., NEX23FE(25T)) consisting of a copper foil 201 with a thickness of 12 µm and a supporting base 202 as a polyimide film with a thickness of 25 µm, a hole was formed by drilling, directly plated, and then electrolytically plated with copper to form a through-hole 203 for electric conduction between the front and the rear faces, and then etching was conducted to form a pad 204 capable of receiving an interconnection pattern and the conductor post 1045. Then, in the interconnection pattern 205 in the part corresponding to a flexible part 330, a surface coating 206 was formed by a polyimide (Kanegafuchi Chemical Ind. Co., Ltd., Apical NPI) with a thickness of 12.5 µm and a thermosetting adhesive (in-house developed material, TFF38012MP25) with a thickness of 25 µm. Finally, the product was cut into the outer size to give an inner flexible circuit board 220.

### 3. Preparation of a multilayer flexible circuit board

A multilayer flexible circuit board 310 was prepared as shown in FIG. 3. Using a jig with a pin guide for alignment, the outer single-sided circuit board 120 was laid up on the inner flexible circuit board 220. Then, they were partly temporary-bonded by a spot heater at 250 degrees C. Then, by lamination at 100 degrees C and 0.1 MPa for 60 seconds by a vacuum press, the conductor post 1045 was shaped to be in contact with the conductor pad, to bury the circuit in the inner flexible circuit board 220 having the conductor pad by shaping. Then, the product was pressed by a hydraulic press at 260 degrees C and 0.005 MPa for 60 seconds, to initiate solder-melting bonding of the conductor post 1045 to the pad 204 in the inner flexible circuit board 220 via the adhesion layer 111 and thus to form a solder bonding and a solder fillet for interlayer bonding. Subsequently, the adhesive was cured by heating at 180 degrees C for 60 minutes to give a multilayer flexible circuit board 3110 in which the layers were laminated.

Each of the multilayer flexible circuit boards prepared as described above was evaluated as follows. The results are shown in Table 2.
(1) Solder bonding part: a cross-section of a solder bonding part was visually observed using a microscope.
(2) Electric connection: a substrate for evaluation having 1000 bumps/pt was examined for their electric bonding by a checker. A product in which all the bumps were connected was passed.
(3) Hygroscopic reflow: after treating under the conditions of 30 degrees C/60 %/168 hours, solder reflow was conducted three times at the maximum temperature of 260 degrees C, and a product without peeling or delamination was passed.
(4) Temperature cycling test: a conductive resistance was determined before and after treatment at 1000 cycles of -65 degrees C/30 min and 125 degrees C/30 min in, and a product was passed when a variation was equal to or less than 10 %.
(5) Insulation resistance: a product was passed when an insulation resistance after treatment under the conditions of equal to or more than 30 degrees C/85 %/DC 50V/240 hours was 108 Ω.

[Table 2]

**(Table 2)**

| | Microscopic observation of a solder joint | Checker of electric connection | Hygroscopic solder reflow test | Temperature cycle test | Insulation resistance after moisture absorption |
|---|---|---|---|---|---|
| Ex. 1 | Good | Passed | Passed | Passed | Passed |
| Ex. 2 | Good | Passed | Passed | Passed | Passed |
| Ex. 3 | Good | Passed | Passed | Passed | Passed |
| Ex. 4 | Good | Passed | Passed | Passed | Passed |
| Ex. 5 | Good | Passed | Passed | Passed | Passed |
| Ex. 6 | Good | Passed | Passed | Passed | Passed |
| Comp. Ex. 1 | NG (inadequate wetting) | NG | Passed | - | - |
| Comp. Ex. 2 | Good | Passed | NG | Passed | Passed |
| Comp. Ex. 3 | NG (inadequate wetting) | NG | Passed | - | - |

### Industrial Applicability

According to the present invention, a smaller and thinner multilayer circuit board meeting the requirements for high-density mounting can be obtained because it can have a pad-on-via structure. Thus, it can be used for mobile devices which are required to be size-reduced, such as a cell phone, a digital video camera, a digital camera and a mininote personal computer. Furthermore, reliable connection can be achieved with a low profile while connection was conventionally made via connector components.

## Claims

1. A resin composition used for a resin layer in a sheet-formed carrier material with a resin for bonding between substrates in which a metal conductive material is formed, comprising:
a polyfunctional epoxy resin (a) having three or more glycidyl ether groups with an epoxy equivalent of 100 to 300,
a compound (b) having one or more carboxyl groups with a melting point of equal to or more than 50 degrees C and equal to or less than 230 degrees C or less, and
a curing agent (c).

2. The resin composition according to Claim 1, wherein said carboxyl-containing compound (b) has a boiling point or decomposition point of 240 degrees C or more.

3. The resin composition according to Claim 1 or 2, wherein said polyfunctional epoxy resin (a) is selected from the group consisting of naphthalene framework type epoxy resins, glycidyl amine type epoxy resins, solid epoxy resins and cyclopentadiene type epoxy resins.

4. The resin composition according to Claim 3, wherein said solid epoxy resin is represented by general formula (1): 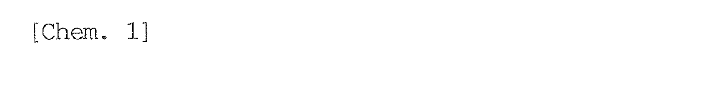 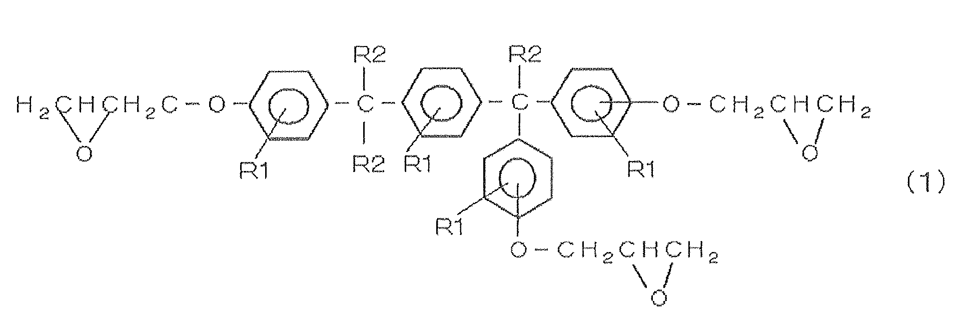 [In general formula (1), R1 represents halogen or alkyl group having 1 to 3 carbon atoms, and can be identical or different. R2 represents hydrogen or methyl group, and can be identical or different between each other.]

5. The resin composition according to Claim 4, wherein each of R2 in general formula (1) is methyl.

6. The resin composition according to Claim 1 or 2, wherein said compound (b) having one or more carboxyl groups is an aromatic carboxylic acid.

7. The resin composition according to Claim 6, wherein said aromatic carboxylic acid is selected from the group consisting of benzoic acid, o-methylbenzoic acid, m-methylbenzoic acid, p-methylbenzoic acid, benzophenone-2-carboxylic acid, 2-biphenylcarboxylic acid and 4-biphenylcarboxylic acid.

8. The resin composition according to any of Claims 1 to 5, wherein said compound (b) having one or more carboxyl groups is a linear saturated dicarboxylic acid.

9. The resin composition according to any of Claims 3 to 5, wherein said compound (b) having one or more carboxyl groups is selected from the group consisting of benzoic acid, o-methylbenzoic acid, m-methylbenzoic acid, p-m.ethylbenzoic acid, benzophenone-2-carboxylic acid, sebacic acid, 2--biphenylcarboxylic acid and 4-biphenylcarboxylic acid.

10. The resin composition according to Claim 9, wherein said compound (b) having one or more carboxyl groups is selected from the group consisting of benzoic acid, o-methylbenzoic acid, m-methylbenzoic acid and p-methylbenzoic acid.

11. The resin composition according to any of Claims 1 to 10, further comprising a synthetic rubber elastomer.

12. The resin composition according to Claim 11, wherein said synthetic rubber elastomer has a weight average molecular weight of equal to more than 500,000.

13. The resin composition according to Claim 11 or 12, comprising equal to or more than 5 parts by weight or equal to or less than 30 parts by weight of said synthetic rubber elastomer to 100 parts by weight of the total of said polyfunctional epoxy resin (a) and said curing agent (c).

14. The resin composition according to any of Claims 11 to 13, wherein said synthetic rubber elastomer is carboxylic acid-modified.

15. The resin composition according to any of Claims 1 to 14, comprising 3 to 15 parts by weight of said compound (b) having one or more carboxyl groups to 100 parts by weight of the total of said polyfunctional epoxy resin (a) and said curing agent (c).

16. The resin composition as claimed according to any of Claims 1 to 15, wherein said curing agent (c) comprises a novolac phenol resin.

17. The resin composition according to Claim 16, wherein said novolac phenol resin is contained in 0.8 to 1.2 equivalents to said polyfunctional epoxy resin (a).

18. A carrier material with a resin, wherein the resin composition according to any of Claims 1 to 17 is laminated on a carrier material.

19. The carrier material with a resin according to Claim 18, wherein said carrier material is a metal foil or resin film.

20. A multi-layered printed circuit board prepared by laminating the carrier material with a resin according to Claim 18 or 19 on one side or both sides of an inner circuit board and pressing the laminate with heating.

21. A semiconductor device comprising the multi-layered printed circuit board according to Claim 20.
